# FASCICULE DE BREVET EUROPEEN

(11) **EP 3 226 303 B1**
(45) Date de publication et mention de la délivrance du brevet: **07.07.2021**
(21) Numéro de dépôt: 16184603.5
(22) Date de dépôt: 17.08.2016
(51) Int. Cl.: H01L 29/747, H01L 29/74, H01L 29/417, H01L 29/423

(54) **COMPOSANT DE PUISSANCE PROTÉGÉ CONTRE LES SURCHAUFFES**
LEISTUNGSKOMPONENTE MIT ÜBERHITZUNGSSCHUTZ
POWER COMPONENT PROTECTED AGAINST OVERHEATING

(30) Priorité: 31.03.2016 FR 1652822
(43) Date de publication de la demande: 04.10.2017
(73) Titulaire: STMicroelectronics (Tours) SAS, 37100 Tours (FR)
(72) Inventeur: MENARD, Samuel, 37000 TOURS (FR)
(74) Mandataire: Cabinet Beaumont

(56) Documents cités:
- EP-A1- 1 544 919
- FR-A1- 2 974 447
- JP-A- S59 215 773
- US-A- 4 982 261
- US-A1- 2013 228 822
- US-A1- 2015 084 094
- None

## Description

### Domaine

La présente demande concerne des composants de puissance protégés contre des surchauffes, et plus particulièrement des triacs et des thyristors à structure verticale protégés contre des augmentations de température.

### Exposé de l'art antérieur

Les triacs et les thyristors à structure verticale sont des commutateurs électroniques de puissance comprenant un empilement d'au moins quatre couches et/ou régions semiconductrices de types de conductivité alternés. Dans ces composants, une première métallisation ou électrode principale A1 repose sur une face principale de l'empilement. Une deuxième métallisation ou électrode principale A2 repose sur l'autre face principale de l'empilement. Une métallisation ou électrode de gâchette G repose sur la même face de l'empilement que l'électrode principale A1.

De manière générale, lorsqu'une différence de potentiel est présente entre les électrodes principales A1 et A2 d'un de ces composants, le passage d'un courant électrique entre ces électrodes principales A1 et A2 est conditionné par l'application d'un courant de gâchette sur l'électrode de gâchette. Une fois le passage du courant établi entre les électrodes principales, ces composants continuent à conduire le courant jusqu'à ce que celui-ci passe en dessous d'une valeur de seuil, appelée courant de maintien. Les documents JP S5921773, US 4982261, US 2015/084094 et EP 1544919 présentent des exemples de tels composants de puissance.

La figure 1 correspond à la figure 7 de la demande de brevet américain N°2015/108537. Cette figure est une vue en coupe d'un exemple d'un triac 1 à structure verticale.

Le triac 1 est formé à partir d'un substrat de silicium 3 faiblement dopé de type N (N⁻). Les faces supérieure et inférieure du substrat 3 comprennent des couches 5 et 7 dopées de type P. La couche supérieure 5 contient une région 9 fortement dopée de type N (N⁺) et une région 11 fortement dopée de type N (N⁺). La couche inférieure 7 contient une région 13 fortement dopée de type N (N⁺) dans une zone sensiblement complémentaire de celle occupée, en vue de dessus, par la région 9. Une électrode principale A1 est disposée sur la face supérieure du substrat 3, à cheval sur la région N⁺ 9 et une partie de la couche 5 dopée du type P. Une électrode principale A2 est disposée sur la face inférieure du substrat 3, à cheval sur la région N⁺ 13 et une partie de la couche 7 dopée du type P. Une électrode de gâchette G est disposée sur la face supérieure du substrat 3, à cheval sur la région N⁺ 11 et une partie de la couche 5 dopée du type P.

Lorsque le triac 1 est à l'état bloqué et qu'un signal de gâchette est appliqué sur la borne G, un courant de gâchette IGK circule à travers la couche P 5 entre les bornes G et A1, la couche P 5 constituant une résistance RGK entre ces bornes. Si le courant de gâchette IGK est supérieur, en valeur absolue, au courant de déclenchement du triac 1, la chute de tension VGK entre les bornes G et A1 est suffisante pour déclencher le triac 1 qui passe de l'état bloqué à l'état passant.

Un inconvénient du triac 1 est que, lorsque sa température augmente, la résistivité de la couche P 5, et donc la valeur de la résistance équivalente RGK, augmentent. Ainsi, le passage d'un courant IGK entre les bornes G et A1, même si ce courant est inférieur au courant normal de déclenchement, peut provoquer une chute de tension élevée dans la couche P 5 entraînant un déclenchement parasite du triac 1. Ces déclenchements parasites contribuent à une augmentation croissante de la température du triac jusqu'à une valeur élevée pouvant entraîner une dégradation, voire une destruction du triac. Le même problème se pose avec les thyristors.

La figure 2 correspond à la figure 3(a) de la demande de brevet américain N°2012/0250200. Cette figure est le schéma du circuit électrique d'un exemple de protection d'un triac 20 contre des surchauffes.

Le triac 20 comprend des bornes principales A1 et A2, et une borne de gâchette G. Une diode de Shockley 30 est connectée entre la borne G et la borne A1 du triac 20. La diode de Shockley 30 est liée thermiquement au triac 20.

En fonctionnement, la diode de Shockley 30 est initialement à l'état bloqué et le triac 20 fonctionne normalement. Quand le triac 20 surchauffe, la température de la diode de Shockley augmente et son seuil de déclenchement diminue. Ainsi, lorsqu'un signal de gâchette est appliqué sur la borne G, ce signal est dévié à travers la diode de Shockley. Il en résulte qu'aucun courant ne circule dans la résistance RGK court-circuitée par la diode de Shockley, et le triac 20 reste à l'état bloqué. Cela permet d'éviter que la température du triac ne continue à augmenter, empêchant ainsi sa dégradation ou sa destruction.

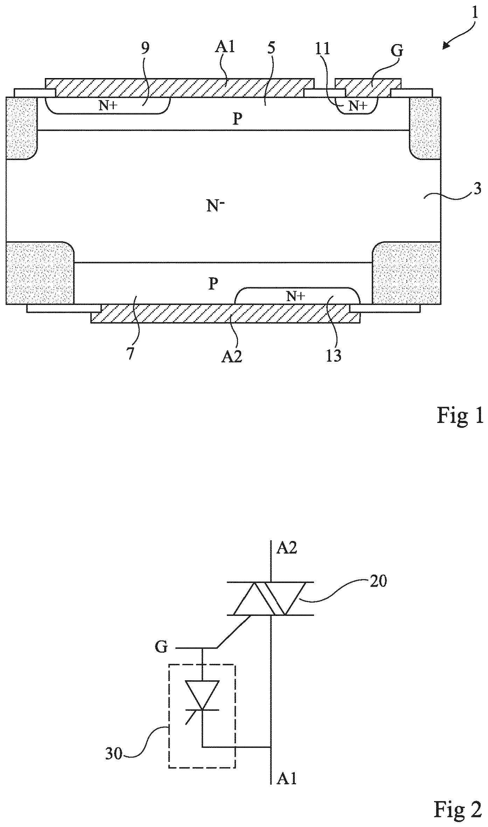

La protection décrite en relation avec la figure 2 est relativement difficile à mettre en oeuvre et à régler, et est, en outre, relativement encombrante.

Il serait donc souhaitable de disposer de triacs et de thyristors comprenant une protection contre les surchauffes palliant au moins certains des inconvénients des protections existantes.

### Résumé

Ainsi, un mode de réalisation prévoit un triac à structure verticale tel que défini dans la revendication 1 comprenant, du côté de la face supérieure d'un substrat en silicium : une métallisation principale dont une première partie repose sur une première région d'un premier type de conductivité formée dans une couche du deuxième type de conductivité, et dont une deuxième partie repose sur une partie de ladite couche ; une métallisation de gâchette reposant sur une deuxième région du premier type de conductivité formée dans ladite couche, au voisinage de la première région ; et au moins un barreau de silicium poreux formé dans ladite couche, une première extrémité dudit barreau étant en contact avec la métallisation de gâchette, et la deuxième extrémité dudit barreau étant en contact avec la métallisation principale.

Selon un mode de réalisation, la métallisation de gâchette est en contact électrique avec la deuxième région et ledit au moins un barreau uniquement.

Selon un mode de réalisation, le triac comprend un premier barreau de silicium poreux dont la deuxième extrémité est en contact avec ladite première partie de la métallisation principale, et un deuxième barreau de silicium poreux dont la deuxième extrémité est en contact avec ladite deuxième partie de la métallisation principale.

Selon un mode de réalisation, le triac comprend un barreau dont une première partie s'étend dans ladite première région et dont une deuxième partie s'étend dans ladite partie de ladite couche.

Un autre mode de réalisation prévoit un thyristor à structure verticale tel que défini dans la revendication 5 comprenant, du côté de la face supérieure d'un substrat en silicium : une métallisation principale reposant sur une première région d'un premier type de conductivité formée dans une couche du deuxième type de conductivité ; une métallisation de gâchette reposant sur une deuxième région en silicium poreux ou en silicium dopé du premier type de conductivité formé dans ladite couche, au voisinage de ladite première région ; et au moins un barreau de silicium poreux formé dans ladite couche, une première extrémité dudit barreau étant en contact avec la métallisation de gâchette, et la deuxième extrémité dudit barreau étant en contact avec la métallisation principale.

Selon un mode de réalisation, entre ses première et deuxième extrémités, le barreau comprend une portion s'étendant dans ladite première région.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, décrite précédemment, correspond à la figure 7 de la demande de brevet américain N°2015/108537 ;
la figure 2, décrite précédemment, correspond à la figure 3(a) de la demande de brevet américain N°2012/0250200 ;
les figures 3A à 3C représentent schématiquement un mode de réalisation d'un triac protégé contre les augmentations de température ;
la figure 4 représente schématiquement une variante de réalisation du triac des figures 3A à 3C ; et
les figures 5A et 5B représentent schématiquement un mode de réalisation d'un thyristor protégé contre les augmentations de température.

### Description détaillée

De mêmes éléments ont été désignés par de mêmes références dans les différentes figures et, de plus, les diverses figures ne sont pas tracées à l'échelle.

Dans la description qui suit, les termes "droite", "supérieur", "inférieur", etc., se réfèrent à l'orientation des éléments concernés dans les figures correspondantes. Sauf précision contraire, les expressions "disposé sur" et "reposant sur" signifient "disposé sur et en contact avec" et "reposant sur et en contact avec".

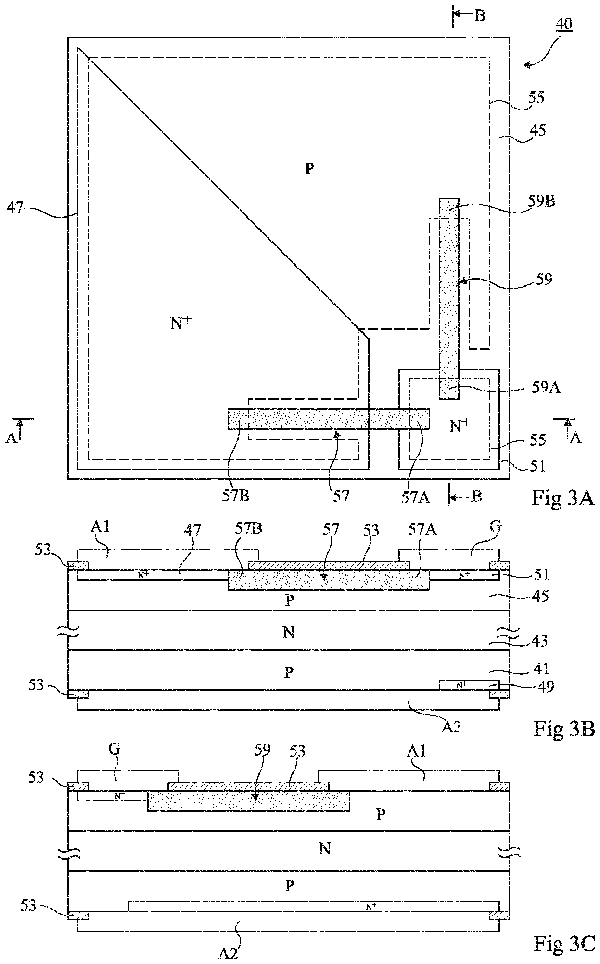

Les figures 3A, 3B et 3C représentent schématiquement un mode de réalisation d'un triac 40 protégé contre les surchauffes, la figure 3A étant une vue de dessus et les figures 3B et 3C étant des vues en coupe selon les plans respectivement AA et BB de la figure 3A.

Le triac 40 comprend des couches de silicium 41, 43 et 45 de types de conductivité alternés, respectivement PN⁻P, correspondant respectivement à la couche 7, au substrat 3, et à la couche 5 du triac 1 décrit en relation avec la figure 1. Une région 47 en silicium fortement dopé de type N (N⁺) est formée dans la couche P supérieure 45, et une région 49 en silicium fortement dopé de type N (N⁺) est formée dans la couche P inférieure 41. Dans un coin du triac 40, une région 51 en silicium fortement dopé de type N (N⁺) est formée dans la couche P supérieure 45 au voisinage de la région N⁺ 47. Dans ce mode de réalisation, la région N⁺ 51 a, en vue de dessus, la forme d'un carré. En outre, la région N⁺ 47 a, en vue de dessus, la forme d'un triangle comprenant un angle rogné (à droite en figure 3A) et en vis-à-vis de la région N⁺ 51. Bien que cela ne soit pas visible dans les figures 3A à 3C, la région N⁺ 49 occupe une zone sensiblement complémentaire, en vue de dessus, de celle occupée par la région N⁺ 47.

Une métallisation principale supérieure A1 repose sur la face supérieure de l'empilement de couches et/ou régions 41, 43, 45, 47, 49 et 51, à cheval sur la région N⁺ 47 et la couche P supérieure 45. Une métallisation principale A2 repose sur la face inférieure de l'empilement, à cheval sur la région N⁺ 49 et la couche P inférieure 41. Une métallisation de gâchette G repose sur la région N⁺ 51. Des couches isolantes 53 sont disposées sur les faces supérieure et inférieure de l'empilement, et délimitent les surfaces de contact électrique entre les métallisations A1, A2 et G d'une part, et les régions et/ou couches semiconductrices de l'empilement d'autre part. Ces surfaces de contact électrique sont délimitées par des traits pointillés 55 en figure 3A.

Le triac 40 comprend, en outre, deux barreaux 57 et 59 en silicium poreux formés dans la couche P 45. Une extrémité 57A du barreau 57 est disposée dans la région N⁺ 51, en contact avec la métallisation de gâchette G, l'autre extrémité 57B du barreau 57 étant disposée dans la région N⁺ 47, en contact avec la métallisation principale A1. Une extrémité 59A du barreau 59 est disposée dans la région N⁺ 51, en contact avec la métallisation de gâchette G. L'autre extrémité 59B du barreau 59 est disposée dans une portion de la couche P 45 sur laquelle repose une partie de la métallisation A1, l'extrémité 59B du barreau étant en contact avec cette partie de la métallisation A1. Entre leurs extrémités, les barreaux 57 et 59 sont recouverts de la couche isolante supérieure 53. Ainsi, bien qu'une portion du barreau 57 s'étende dans la région N⁺ 51 et qu'une portion du barreau 59 s'étende dans la portion de la couche P revêtue de la métallisation A1, ces portions des barreaux 57 et 59 ne sont pas en contact électrique avec la métallisation A1. En outre, la métallisation de gâchette G n'est en contact électrique qu'avec la région N⁺ 51 et les extrémités 57A et 59A des barreaux 57 et 59.

On considère le cas où une différence de potentiel est appliquée entre les bornes A1 et A2. Si un courant de gâchette IGK, positif ou négatif, et supérieur (en valeur absolue) au courant de déclenchement du triac 40, est amené à circuler entre les bornes G et A1, ce courant IGK passe essentiellement dans les barreaux de silicium poreux 57 et 59 qui constituent une résistance RGK entre les bornes G et A1. Pour des températures basses ou peu élevées, la valeur de la résistance RGK est élevée, d'où il résulte que la tension VGK entre les bornes G et A1 est suffisante pour déclencher le triac 40. En revanche, lorsque le triac 40 surchauffe, la valeur de la résistance RGK diminue, d'où il résulte que la tension VGK entre les bornes G et A1 n'est plus suffisante pour déclencher le triac 40 qui reste à l'état bloqué.

La prévision des barreaux 57 et 59 en silicium poreux entre les électrodes G et A1 permet donc d'éviter que le triac 40 ne puisse devenir conducteur dès qu'il surchauffe.

On comprend que, de la même manière que les niveaux de dopage et les dimensions des différentes régions semiconductrices du triac 40 sont choisis en fonction de conditions souhaitées de déclenchement, la porosité et les dimensions des barreaux 57 et 59 sont également choisies pour que le triac 40 ne se déclenche plus à partir d'un certain seuil de température. Pour un seuil donné de température, la porosité et les dimensions des barreaux 57 et 59 peuvent être déterminées aux moyens d'outils de simulation couramment utilisés par l'homme de métier. La réalisation d'une région en silicium poreux, par exemple un barreau, dans une couche semiconductrice dopée est par exemple décrite dans la demande de brevet US N°2015/108537.

De manière avantageuse, les barreaux 57 et 59 sont peu encombrants, et s'étendent de préférence au plus près des zones du triac 40 soumises aux plus fortes augmentations de température. En outre, contrairement au cas où la protection contre les surchauffes est réalisée par une diode de Shockley comme cela est représenté en figure 2, les barreaux 57 et 59 permettent de protéger le triac 40 contre les surchauffes quel que soit le quadrant de fonctionnement de celui-ci.

Le triac 40 décrit précédemment peut être vu comme deux thyristors montés en antiparallèle, un premier thyristor comprenant les couches 47, 45, 43 et 41, et un deuxième thyristor comprenant les couches 49, 41, 43 et 45. Le barreau 57 est plus sensible aux surchauffes du premier thyristor et le barreau 59 est plus sensible aux surchauffes du deuxième thyristor. La protection contre les surchauffes décrite ci-dessus permet donc avantageusement de tenir compte des augmentations de température se produisant dans l'un ou l'autre des thyristors composant le triac 40.

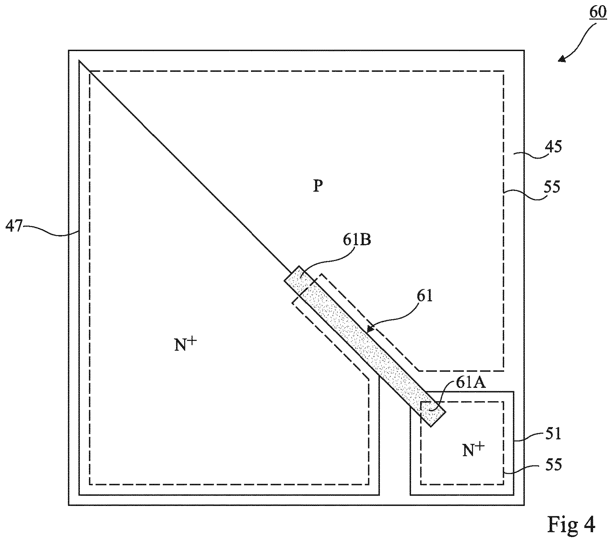

La figure 4 est une vue de dessus d'une variante de réalisation du triac des figures 3A à 3C.

Le triac 60 de la figure 4 comprend de mêmes éléments que le triac 40 des figures 3A à 3C à la différence que les barreaux 57 et 59 en silicium poreux sont remplacés par un unique barreau 61 en silicium poreux. Une extrémité 61A du barreau 61 est disposée dans la région N⁺ 51, en contact avec la métallisation de gâchette G. L'autre extrémité 61B du barreau est disposée dans la couche P 45, en contact avec la métallisation A1. Entre ses extrémités 61A et 61B, le barreau comprend une portion s'étendant dans la couche P 45 et la région N⁺ 47. Une première moitié environ de cette portion du barreau 61 s'étend dans la couche P 45, et la deuxième moitié environ de cette portion du barreau 61 s'étend dans la région N⁺ 47. Entre ces extrémités 61A et 61B, le barreau est revêtu de la couche isolante 53. Ainsi, la portion du barreau 61 s'étendant dans la couche P et dans la région N⁺ 47 n'est pas en contact électrique avec la métallisation A1. Dans le triac 40 de la figure 4, la métallisation de gâchette G n'est en contact électrique qu'avec la région N⁺ 51 et l'extrémité 61A du barreau 61.

De manière avantageuse, l'extrémité 61B du barreau 61 est disposée dans une zone sensiblement centrale du triac, c'est-à-dire dans la zone la plus représentative de la température du triac.

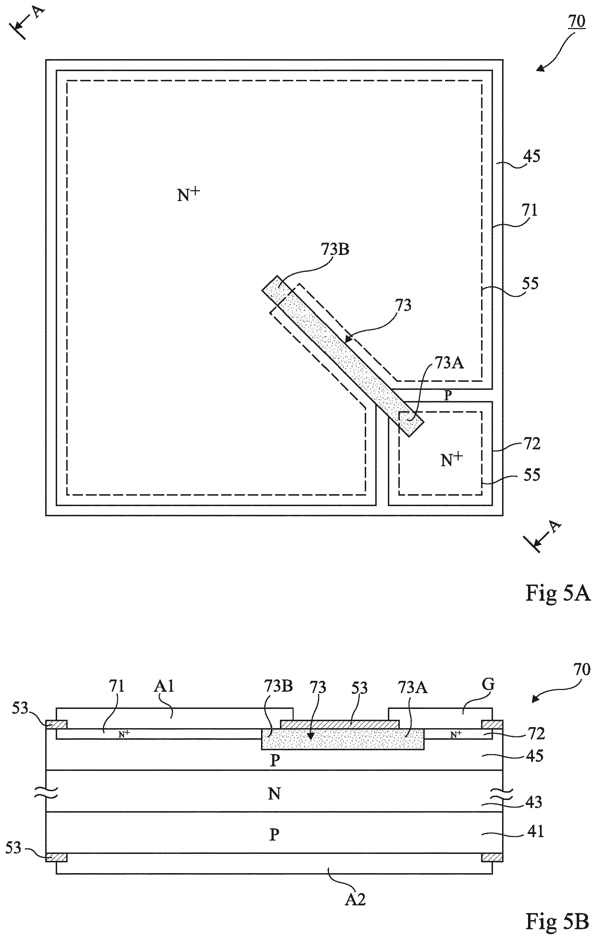

Les figures 5A et 5B représentent schématiquement un mode de réalisation d'un thyristor 70 protégé contre les augmentations de température, la figure 5A étant une vue de dessus et la figure 5B étant une vue en coupe selon le plan AA de la figure 5A.

Le thyristor 70 comprend des couches de silicium 41, 43 et 45 de types de conductivité alternés, respectivement PN⁻P. Une région 71 de silicium fortement dopé de type N (N⁺) est formée dans une partie principale de la couche P supérieure 45. En vue de dessus, la région N⁺ 71 a par exemple une forme sensiblement carrée. Une métallisation principale supérieure A1 repose sur cette région N⁺ 71, une métallisation principale inférieure A2 repose sur la couche P inférieure 41. Dans un coin du thyristor, une métallisation de gâchette G repose sur une région 72 fortement dopée de type N (N⁺) formée dans la couche P supérieure 45. Il est intéressant de constater que, dans cette configuration, le thyristor peut être amorcé à la fois par un courant de gâchette positif et négatif, ce n'est pas le cas des thyristors conventionnels où seul l'amorçage positif est possible. En variante, la région 72 peut être en silicium poreux plutôt qu'en silicium fortement dopé de type N (N⁺). Dans ce mode de réalisation, des couches isolantes 53 sont disposées sur les faces supérieure et inférieure de l'empilement, et délimitent les surfaces de contact électrique entre les métallisations A1, A2 et G, d'une part, et les régions et/ou couches semiconductrices de l'empilement, d'autre part. Ces surfaces de contact électrique sont délimitées par des traits pointillés 55 en figure 5A.

Un barreau 73 en silicium poreux est formé dans la couche 45. Une extrémité 73A du barreau 73 est disposée sous la métallisation G et est en contact avec celle-ci. L'autre extrémité 73B du barreau 73 est disposée sous la métallisation A1 et est en contact avec celle-ci. Entre ses extrémités 73A et 73B, le barreau 73 est revêtu de la couche isolante 53. Ainsi, bien que, entre ses extrémités 73A et 73B, le barreau 73 comprenne une portion s'étendant dans la région N⁺ 71, cette portion n'est pas en contact électrique avec la métallisation A1. En outre, la métallisation de gâchette G n'est en contact électrique qu'avec la région 72 et l'extrémité 73A du barreau 73.

En fonctionnement, de manière similaire à ce qui a été décrit pour les triacs des figures 3A à 4, lorsqu'un courant de gâchette IGK est amené à circuler entre les bornes G et A1, ce courant passe essentiellement à travers le barreau 73 qui constitue une résistance RGK entre ces bornes. Pour des températures normales de fonctionnement, la résistance équivalente RGK a une valeur élevée. Ainsi, lorsque le courant IGK est supérieur au courant normal de déclenchement du thyristor, la chute de tension VGK entre les métallisations G et A1 est suffisante pour déclencher le thyristor. En revanche, lorsque le thyristor surchauffe, la valeur de la résistance RGK diminue, d'où il résulte que la chute de tension VGK entre les métallisations G et A1 n'est plus suffisante pour déclencher le thyristor qui reste à l'état bloqué.

De manière avantageuse, l'extrémité 73B du barreau 73 est disposée dans une zone sensiblement centrale de la région N⁺ 71, c'est-à-dire dans la zone du thyristor soumise aux plus fortes augmentations de température.

Comme pour les triacs 40 décrits précédemment, la disposition du barreau 73 dans le thyristor 70 peut être modifiée par l'homme de métier, de sorte que le barreau soit au plus près des zones du thyristor soumises aux plus fortes augmentations de température. On peut également prévoir de disposer plus d'un barreau en silicium poreux dans le thyristor de manière à être sensible aux augmentations de température se produisant dans différentes zones du thyristor.

A titre d'exemple, la résistivité à 25°C du silicium poreux des barreaux 57, 59, 61 et 73 est choisie dans une plage allant de 10³ à 10⁴ ohm.cm. En outre, dans une filière technologique permettant la réalisation en silicium de composants intégrés de puissance tels que ceux décrits précédemment, les épaisseurs des différentes couches et/ou régions seront :
- de 5 à 20 µm, par exemple 10 µm, pour les régions 47, 49, 51 et 71,
- de 10 à 50 µm, par exemple 35 µm, pour les couches 41 et 45,
- de 10 à 25 µm, par exemple 15 µm, pour les barreaux 57, 59, 61 et 73, et
- de 50 à 200 µm, par exemple 100 µm, pour la couche 43.
Les concentrations de dopage seront, par exemple :
- de l'ordre de 10¹⁴ à 10¹⁵ at./cm³ pour la couche 43 faiblement dopée de type N (N⁻),
- de l'ordre de 10²⁰ at./cm³ pour les régions 47, 49, 51 et 71 fortement dopées de type N (N⁺), et
- de l'ordre de 5.10¹⁷ à 5.10¹⁸ at./cm³ pour les couches 41 et 45 dopées de type P.

Plus généralement, en termes relatifs, l'épaisseur des barreaux 57, 59, 61 et 73 est par exemple comprise entre 0,5 et 1 fois l'épaisseur de la couche 45.

Des modes de réalisation particuliers ont été décrits. Diverses variantes et modifications apparaîtront à l'homme de l'art. En particulier, bien que l'on ait décrit des formes particulières pour les régions 47, 49, 51, 71 et 73 et pour les métallisations G, A1 et A2, on comprend que ces formes peuvent être modifiées. Par exemple, dans le thyristor 70 des figures 5A et 5B, la région N⁺ 71 peut être interrompue par des courts-circuits d'émetteur, c'est-à-dire des régions dans lesquelles le matériau de la couche P 45 vient au contact de la métallisation A1. On a décrit une disposition particulière de la métallisation de gâchette par rapport à la métallisation principale A1, les modes de réalisation décrits ci-dessus peuvent être adaptés à d'autres dispositions des métallisations G et A1, par exemple à des structures à gâchette centrale.

Dans la description précédente, on a toujours considéré des barreaux rectilignes. Ces barreaux peuvent être courbes ou ondulés.

## Revendications

1. Triac (40, 60) à structure verticale comprenant, du côté de la face supérieure d'un substrat (43) en silicium :
une métallisation principale (A1) dont une première partie repose sur une première région (47) d'un premier type de conductivité formée dans une couche (45) du deuxième type de conductivité, et dont une deuxième partie repose sur une partie de ladite couche ; et
une métallisation de gâchette (G) reposant sur une deuxième région (51) du premier type de conductivité formée dans ladite couche (45), au voisinage de la première région (47) ; et
un ou plusieurs barreaux (57, 59, 61) de silicium poreux formé dans ladite couche, une première extrémité (57A, 59A, 61A) de chaque barreau étant en contact avec la métallisation de gâchette, et une deuxième extrémité (57B, 59B, 61B) de chaque barreau étant en contact avec la métallisation principale, chaque barreau ayant une résistance élevée à température normale et une résistance plus faible à température élevée et étant adapté à faire circuler un courant entre la métallisation principale (A1) et la métallisation de gâchette (G).

2. Triac selon la revendication 1, dans lequel la métallisation de gâchette (G) est en contact électrique avec la deuxième région (51) et chaque barreau (57, 59, 61) uniquement.

3. Triac selon la revendication 1 ou 2, dans lequel ledit un ou plusieurs barreaux comprend un premier barreau (57) de silicium poreux dont la deuxième extrémité (57B) est en contact avec ladite première partie de la métallisation principale (A1), et un deuxième barreau (59) de silicium poreux dont la deuxième extrémité (59B) est en contact avec ladite deuxième partie de la métallisation principale.

4. Triac selon l'une quelconque des revendications 1 à 3, dans lequel ledit un ou plusieurs barreaux comprend un barreau (61) comportant entre ses première (61A) et deuxième (61B) extrémités, une première partie s'étendant dans ladite première région (47) et une deuxième partie s'étendant dans ladite partie de ladite couche (45).

5. Thyristor (70) à structure verticale comprenant, du côté de la face supérieure d'un substrat (43) en silicium :
une métallisation principale (A1) reposant sur une première région (71) d'un premier type de conductivité formée dans une couche (45) du deuxième type de conductivité ; et
une métallisation de gâchette (G) reposant sur une deuxième région (72) en silicium poreux ou en silicium dopé du premier type de conductivité formé dans ladite couche, au voisinage de ladite première région ; et
un ou plusieurs barreaux (73) de silicium poreux formé dans ladite couche, une première extrémité (73A) de chaque barreau étant en contact avec la métallisation de gâchette, et la deuxième extrémité (73B) de chaque barreau étant en contact avec la métallisation principale, chaque barreau ayant une résistance élevée à température normale et une résistance plus faible à température élevée et étant adapté à faire circuler un courant entre la métallisation principale (A1) et la métallisation de gâchette (G).

6. Thyristor selon la revendication 5, dans lequel, entre ses première et deuxième extrémités, chaque barreau comprend une portion s'étendant dans ladite première région (71).

## Patentansprüche

1. Triac (40, 60) mit einer vertikalen Struktur, die auf der Oberseite eines Siliziumsubstrats (43) Folgendes umfasst:
eine Hauptmetallisierung (A1) mit einem ersten Abschnitt, der auf einem ersten Bereich (47) eines ersten Leitfähigkeitstyps ruht, wobei der erste Bereich in einer Schicht (45) eines zweiten Leitfähigkeitstyps ausgebildet ist, und mit einem zweiten Abschnitt, der auf einem Teil der Schicht ruht; und
eine Gate-Metallisierung (G), die auf einem zweiten Bereich (51) des ersten Leitfähigkeitstyps ruht, wobei der zweite Bereich in der Nähe des ersten Bereichs (47) in der Schicht (45) ausgebildet ist; und
einen oder mehrere poröse Siliziumstäbe (57, 59, 61), die in der Schicht ausgebildet sind, wobei ein erstes Ende (57A, 59A, 61A) jedes Stabes in Kontakt mit der Gate-Metallisierung steht und ein zweites Ende (57B, 59B, 61B) jedes Stabes in Kontakt mit der Hauptmetallisierung steht, wobei jeder Stab bei normaler Temperatur einen hohen Widerstand und bei hoher Temperatur einen niedrigeren Widerstand aufweist und so beschaffen ist, dass er einen Stromfluss zwischen der Hauptmetallisierung (A1) und der Gate-Metallisierung (G) bewirkt.

2. Triac nach Anspruch 1, wobei die Gate-Metallisierung (G) nur mit dem zweiten Bereich (51) und jedem Stab (57, 59, 61) in elektrischem Kontakt steht.

3. Triac nach Anspruch 1 oder 2, wobei der eine oder die mehreren Stäbe einen ersten porösen Siliziumstab (57) umfassen, dessen erstes Ende (57B) in Kontakt mit dem ersten Abschnitt der Hauptmetallisierung (A1) steht, und einen zweiten porösen Siliziumsteg (59) umfassen, dessen zweites Ende (59B) in Kontakt mit dem zweiten Abschnitt der Hauptmetallisierung steht.

4. Triac nach einem der Ansprüche 1 bis 3, wobei der eine oder die mehreren Stäbe einen Stab (61) umfassen, der zwischen seinem ersten (61A) und zweiten (61B) Ende einen ersten Abschnitt aufweist, der sich in dem ersten Bereich (47) erstreckt, und einen zweiten Abschnitt aufweist, der sich in dem Teil der Schicht (45) erstreckt.

5. Ein Thyristor (70) mit einer vertikalen Struktur, der auf der Oberseite eines Siliziumsubstrats (43) Folgendes umfasst:
eine Hauptmetallisierung (A1), die auf einem ersten Bereich (71) eines ersten Leitfähigkeitstyps ruht, wobei der erste Bereich in einer Schicht (45) des zweiten Leitfähigkeitstyps ausgebildet ist; und
eine Gate-Metallisierung (G), die auf einem zweiten Bereich (72) aus porösem Silizium oder dotiertem Silizium des ersten Leitfähigkeitstyps ruht, wobei der zweite Bereich in der Schicht in der Nähe des ersten Bereichs ausgebildet ist; und
einen oder mehrere poröse Siliziumstäbe (73), die in der Schicht ausgebildet sind, wobei ein erstes Ende (73A) jedes Stabes in Kontakt mit der Gate-Metallisierung steht und das zweite Ende (73B) jedes Stabes in Kontakt mit der Hauptmetallisierung steht, wobei jeder Stab bei normaler Temperatur einen hohen Widerstand und bei hoher Temperatur einen niedrigeren Widerstand aufweist und so beschaffen ist, dass er einen Stromfluss zwischen der Hauptmetallisierung (A1) und der Gate-Metallisierung (G) bewirkt.

6. Thyristor nach Anspruch 5, wobei jeder Stab zwischen seinem ersten und zweiten Ende einen Abschnitt aufweist, der sich in dem ersten Bereich (71) erstreckt.

## Claims

1. A triac (40, 60) having a vertical structure, comprising, on the upper surface side of a silicon substrate (43):
a main metallization (A1) having a first portion resting on a first region (47) of a first conductivity type formed in a layer (45) of the second conductivity type, and having a second portion resting on a portion of said layer; and
a gate metallization (G) resting on a second region (51) of the first conductivity type formed in said layer (45), in the vicinity of the first region (47); and
one or several porous silicon bars (57, 59, 61) formed in said layer, a first end (57A, 59A, 61A) of each bar being in contact with the gate metallization, and a second end (57B, 59B, 61B) of each bar being in contact with the main metallization, each bar having a high resistance at normal temperature and a lower resistance at high temperature and being adapted to make a current flow between the main metallization (A1) and the gate metallization (G).

2. The triac of claim 1, wherein the gate metallization (G) is in electric contact with the second region (51) and each bar (57, 59, 61) only.

3. The triac of claim 1 or 2, wherein said one or several bars comprise a first porous silicon bar (57) having its first end (57B) in contact with said first portion of the main metallization (A1), and a second porous silicon bar (59) having its second end (59B) in contact with said second portion of the main metallization.

4. The triac of any of claims 1 to 3, wherein said one or several bars comprise a bar (61) comprising between its first (61A) and second (61B) ends, a first portion extending in said first region (47) and a second portion extending in said portion of said layer (45) .

5. A thyristor (70) having a vertical structure, comprising, on the upper surface side of a silicon substrate (43):
a main metallization (A1) resting on a first region (71) of a first conductivity type formed in a layer (45) of the second conductivity type; and
a gate metallization (G) resting on a second region (72) of porous silicon or doped silicon of the first conductivity type formed in said layer, in the vicinity of said first region; and
one or several porous silicon bars (73) formed in said layer, a first end (73A) of each bar being in contact with the gate metallization, and the second end (73B) of each bar being in contact with the main metallization, each bar having a high resistance at normal temperature and a lower resistance at high temperature and being adapted to make a current flow between the main metallization (A1) and the gate metallization (G).

6. The thyristor of claim 5, wherein, between its first and second ends, each bar comprises a portion extending in said first region (71).
